(19)

Europäisches
Patentamt
European
Patent Office
Office européen
des brevets

(11)     **EP 4 187 792 B1**

(12)                **EUROPEAN PATENT SPECIFICATION**

(45) Date of publication and mention
of the grant of the patent:
**19.03.2025   Bulletin 2025/12**

(21) Application number: **22178075.2**

(22) Date of filing: **09.06.2022**

(51) International Patent Classification (IPC):
*H03M 1/06* (2006.01)      *H03M 1/08* (2006.01)
*H03M 1/12* (2006.01)      *H03M 1/46* (2006.01)

(52) Cooperative Patent Classification (CPC):
**H03M 1/0631; H03M 1/0624; H03M 1/0626;
H03M 1/0836; H03M 1/1245; H03M 1/462;
H03M 1/1215**

(54) **MATRIX PROCESSOR GENERATING SAR-SEARCHED INPUT DELAY ADJUSTMENTS TO CALIBRATE TIMING SKEWS IN A MULTI-CHANNEL INTERLEAVED ANALOG-TO-DIGITAL CONVERTER (ADC)**

MATRIXPROZESSOR, DER SAR-GESUCHTE EINGANGSVERZÖGERUNGSEINSTELLUNGEN ERZEUGT, UM ZEITVERSÄTZE IN EINEM MEHRKANALIGEN VERSCHACHTELTEN ANALOG-DIGITAL-WANDLER (ADC) ZU KALIBRIEREN

PROCESSEUR MATRICIEL GÉNÉRANT DES RÉGLAGES DE TEMPORISATION D'ENTRÉE SAISIS PAR SAR POUR ÉTALONNER LES DÉCALAGES TEMPORELS DANS UN CONVERTISSEUR ANALOGIQUE-NUMÉRIQUE (CAN) MULTICANAUX ENTRELACÉS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.11.2021   US 202117537460**

(43) Date of publication of application:
**31.05.2023   Bulletin 2023/22**

(73) Proprietor: **Caelus Technologies Limited
Sheung Wan (HK)**

(72) Inventors:
• **LOK, Chi Fung
Sheung Wan (HK)**
• **LI, Zhi Jun
Sheung Wan (HK)**

(74) Representative: **Ipside
7-9 Allée Haussmann
33300 Bordeaux Cedex (FR)**

(56) References cited:
**US-A1- 2018 358 976      US-B2- 8 159 377**

• YI RU ET AL: "Digital Compensation for Timing Mismatches in Interleaved ADCs", ASIAN TEST SYMPOSIUM. PROCEEDINGS, IEEE, US, 18 November 2013 (2013-11-18), pages 134 - 139, XP032536904, ISSN: 1081-7735, [retrieved on 20131220], DOI: 10.1109/ATS.2013.34
• MANAR EL-CHAMMAS ET AL: "A 12-GS/s 81-mW 5-bit Time-Interleaved Flash ADC With Background Timing Skew Calibration", IEEE JOURNAL OF SOLID-STATE CIRCUITS, IEEE, USA, vol. 46, no. 4, 3 March 2011 (2011-03-03), pages 838 - 847, XP011351080, ISSN: 0018-9200, DOI: 10.1109/JSSC.2011.2108125
• YIN YONG-SHENG ET AL: "A channel multiplexing digital calibration technique for timing mismatch of time-interleaved ADCs", IEICE ELECTRONICS EXPRESS, vol. 16, no. 19, 1 January 2019 (2019-01-01), pages 20190540 - 20190540, XP093089511, DOI: 10.1587/ elex.16.20190540
• LE DUC HAN ET AL: "Fully Digital Feedforward Background Calibration of Clock Skews for Sub-Sampling TIADCs Using the Polyphase Decomposition", IEEE TRANSACTIONS ON CIRCUITS AND SYSTEMS I: REGULAR PAPERS, IEEE, US, vol. 64, no. 6, 1 June 2017 (2017-06-01), pages 1515 - 1528, XP011651055, ISSN: 1549-8328, [retrieved on 20170525], DOI: 10.1109/ TCSI.2016.2645978

EP 4 187 792 B1

**Description**

**Technical Field**

This invention relates to Analog-to-Digital Converters (ADC), and more particularly to calibration of interleaved ADCs.

**Background of the Invention**

Analog-to-Digital Converters (ADCs) are widely used to convert analog signals to digital values. Multi-bit ADCs have a high resolution, and its accuracy can be improved by calibration. Higher sampling rates can be achieved by interleaving two ADCs that each operate at half the sampling rate.

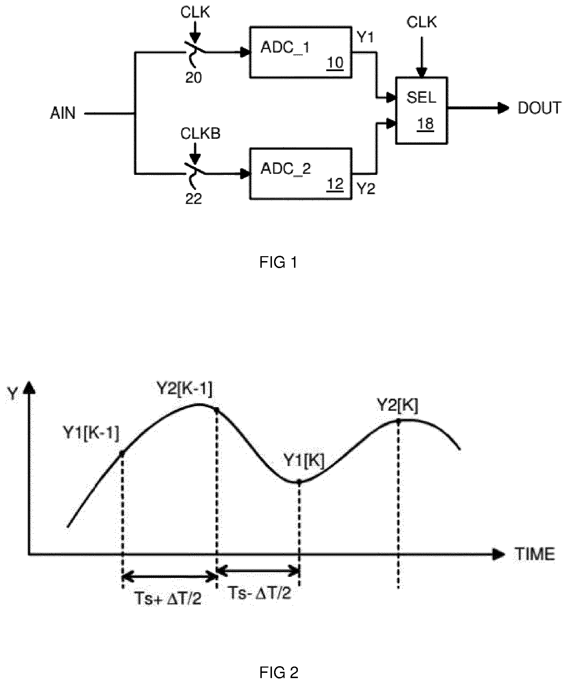

Figure 1 shows a prior-art interleaved ADC. ADC 10 and ADC 12 are interleaved, with ADC 10 sampling analog input AIN when clock CLK closes switch 20, and ADC 12 sampling analog input AIN when inverse clock CLKB closes switch 22. Mux 18 selects digital output Y1 from ADC 10 when CLK is high, when ADC 10 has had sufficient time to sample and hold AIN and convert it to a digital value. The digital output DOUT is Y2 when CLK is low to mux 18. Thus, each of ADC 10, 12 can operate at half the data rate of the final output DOUT.

Figure 2 is a graph of analog sampling and clock skew. AIN is sampled into ADC 10 to generate Y1[K-1] and Y1[K] on the falling edges of CLK, while AIN is sampled into ADC 12 to generate Y2[K-1] and Y2[K] on the falling edges of CLKB, where K is the sample or time-index number. The sampling time or period of AIN is Ts. Ideally there is no clock skew in CLK, and all samples are separated by Ts. However, CLK may not have a pulse width that is exactly 50% of period 2*Ts, introducing sampling pulse-width mismatch and non-linearities. Sampling of channel Y2 may be delayed relative to sampling of channel Y1 by Ts+DT/2, while Sampling of channel Y1 may be delayed relative to sampling of channel Y2 by Ts-DT/2. Ideally DT=0 without mismatch on sampling. However, in reality DT is finite. It is desired to reduce DT to a minimal acceptable level for more than 2 channels.

ADC 10, 12 and switches 20, 22 may not be exactly matched, introducing finite bandwidth mismatches among the two channels Y1, Y2. Thus, both sampling-pulse mismatches and ADC component mismatches may contribute to nonlinearities.

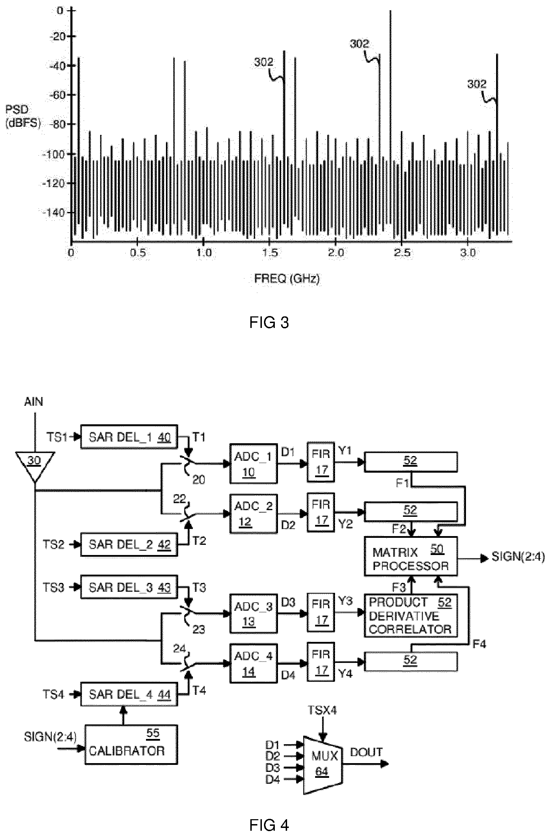

Figure 3 is a graph of spurious tones in a spectrum for a prior-art interleaved ADC. Sampling pulse-width mismatches and component mismatches may introduce nonlinearities or errors that cause spurious tones 302. These spurious tones can occur at integer multiples of Fs/N, K*Fs/N ± F, wherein K is an integer, where Fs is the sampling frequency (period Ts = 1/Fs), and N is the number of channels interleaved together. These spurious tones are undesirable since they can restrict the dynamic range of high-speed ADCs and are proportional to analog input signal amplitude and frequency.

What is desired is a highly-interleaved ADC with at least 3 ADC channels interleaved together for operation at higher sampling rates. It is desired to introduce a variable, programmable delay to each of the channel inputs to correct for timing skews caused by sampling pulse-width, clock, and component mismatches among the 3 or more channels interleaved together. A calibration method is desired to test various values of these delays to program these delays to minimize the skew among the multiple channels. Both a rapid foreground calibration method and a background calibration method to adjust for gradual temperature skews are desired.

The following documents also concern timing skews calibrations in a multi-channel interleaved analog-to-digital converter:

US 2018/358976 A1,
YI RU ET AL: "Digital Compensation for Timing Mismatches in Interleaved ADCs", ASIAN TEST SYMPOSIUM. PROCEEDINGS, IEEE, US, 18 November 2013 (2013-11-18), pages 134-139, XP032536904, ISSN: 1081-7735, DOI: 10.1109/ATS.2013.34.
US 8 159 377 B2.
YIN YONG-SHENG ET AL: "A channel multiplexing digital calibration technique for timing mismatch of time-interleaved ADCs", IEICE ELECTRONICS EXPRESS, vol. 16, no. 19, 1 January 2019 (2019-01-01), pages 20190540-20190540, XP093089511, DOI: 10.1587/ elex.16.20190540
LE DUC HAN ET AL: "Fully Digital Feedforward Background Calibration of Clock Skews for Sub-Sampling TIADCs Using the Polyphase Decomposition", IEEE TRANSACTIONS ON CIRCUITS AND SYSTEMS I: REGULAR PAPERS, IEEE, US, vol. 64, no. 6, 1 June 2017 (2017-06-01), pages 1515-1528, XP011651055, ISSN: 1549-8328, DOI: 10.1109/ TCSI.2016.2645978

## Brief description of the Drawings

Figure 1 shows a prior-art interleaved ADC.
Figure 2 is a graph of analog sampling and clock skew.
Figure 3 is a graph of spurious tones in a spectrum for a prior-art interleaved ADC.
Figure 4 is a block diagram of a 4-channel interleaved ADC with product derivative correlators and a matrix processor for calibration of programmable input delays.
Figure 5 is a diagram of a SAR delay element with binary-weighted capacitors.
Figure 6 is a block diagram of a 3-channel interleaved ADC with details of the product derivative correlators that drive a matrix processor for calibration of programmable input delays.
Figures 7A-7B is a flowchart of foreground calibration of N ADC channels interleaved together.
Figure 8 is a graph of reduced spurious tones in a spectrum for an interleaved ADC with channel input delays calibrated by product derivative correlators and matrix processing.
Figure 9 shows a backend processor triggering background calibration of an interleaved ADC.
Figures 10A-10B show a flowchart of a background calibration process.
Figure 11 shows a non-binary number of ADCs interleaved and calibrated with product derivative correlators and a matrix processor.
Figure 12 shows a non-binary odd number of ADCs interleaved and calibrated with product derivative correlators and a matrix processor.
Figure 13 shows a model of an interleaved ADC.

## Detailed Description of Embodiments

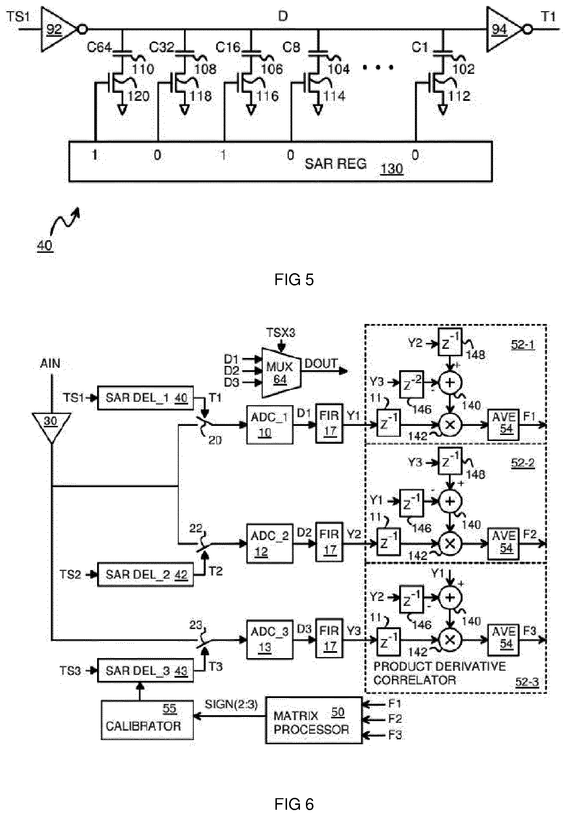

The invention is set out in the appended set of claims.
The following description is presented to enable one of ordinary skill in the art to make and use the invention as provided in the context of a particular application and its requirements. Various modifications to the preferred embodiment will be apparent to those with skill in the art, and the general principles defined herein may be applied to other embodiments.
Figure 4 is a block diagram of a 4-channel interleaved ADC with product derivative correlators and a matrix processor for calibration of programmable input delays. Analog input AIN is buffered by analog buffer 30 and sampled by switches 20, 22, 23, 24 into ADC 10, 12, 13, 14 that generate digital values D1, D2, D3, D4, respectively. Mux 64 alternately selects D1, D2, D3, D4 to generate the final data output DOUT. Final mux 64 operates with clock TSX4 that has four times the frequency of sampling clock TS1.
Sampling clocks TS1, TS2, TS3, TS4 can be a four-phase clock all operating at the same frequency but with phase shifts of 0, 90, 180, and 270 degrees. Sampling clocks TS1, TS2, TS3, TS4 are delayed by variable delays to generate clocks T1, T2, T3, T4 that control switches 20, 22, 23, 24, respectively, that sample AIN to ADC 10, 12, 13, 14 that generate channel digital outputs D1, D2, D3, D4, having phases of 0, 90, 180, and 270 degrees. These variable delays are programmed during calibration with digital values that are stored in a Successive-Approximation-Register (SAR) that enable and disable binary-weighted capacitor delay elements. Calibration uses a Successive-Approximation method testing larger, Most-Significant Bit (MSB) capacitors first, then testing successively smaller capacitors until a Least-Significant Bit (LSB) capacitor is tested.
SAR delay 40 delays sampling clock TS1 to generate T1 to switch 20, while SAR delays 42, 43, 44 delay sampling clocks TS2, TS3, TS4 to generate T2, T3, T4 to switches 22, 23, 24, respectively. By adjusting the delay values programmed into SAR delays 40, 42, 43, 44, the timing skews between channels D1, D2, D3, D4 can be compensated for and matched to within the delay of 1 LSB capacitor in SAR delay 40, 42, 43, 44.
Finite-Impulse-Response (FIR) filters 17 filter digital outputs D1, D2, D3, D4 from ADC 10, 12, 13, 14 to generate filtered digital values Y1, Y2, Y3, Y4. FIR filters 17 can act as lowpass or bandpass filters for calibration.
Product derivative correlators 52 receive filtered digital values Y1, Y2, Y3, Y4 and generate product derivative factors F1, F2, F3, F4. The product derivative factor F2 is a function of the current channel filtered digital value Y2, and the adjacent channels Y1, Y3. In general, the product derivative factor F(X) for a channel X has inputs Y(X), Y(X-1), and Y(X+1), where X-1 and X+1 are modulo N, where N is the number of interleaved channels. Each product derivative correlator 52 generates a correlation factor of the current channel compared to the two adjacent channels. Product derivative correlator 52 can be a mid-point correlator such as shown by the logic implemented of Fig. 6.
Matrix processor 50 receives product derivative factors F1, F2, F3, F4 from product derivative correlators 52, and forms a matrix from F1, F2, F3, F4 that is multiplied by a correlation matrix to generate sign bits. The correlation matrix is constant matrix that is fixed for a fixed number of channels N.

During calibration, the delay in SAR delay 40 is fixed and acts as a timing reference for the other N-1 channels. Therefore, the sign bit for channel 1 is not generated by matrix processor 50.

For a constant or slow-moving analog input AIN, all channels should generate the same filtered digital values Y1, Y2, Y3, Y4. Differences in these values among channels can indicate skews or timing differences.

Product derivative factors F1, F2, F3, F4 each indicate a digital value or timing difference between a channel and its two adjacent channels. These timing differences are combined with all other timing differences by matrix processor 50 to generate the sign bits. The sign bits indicate which channels have larger delays, and which channels have smaller delays.

Calibrator 55 uses these sign bits during a successive-approximation sequence to decide when to keep a test bit set in SAR delay 42, 43, 44 and when to reset the test bit, as successively smaller bit-positions are tested.

Figure 5 is a diagram of a SAR delay element with binary-weighted capacitors. SAR delay 40 has input inverter 92 that inverts input sampling clock TS1 to drive delay node D, and output inverter 94 that drives local sampling clock T1 for channel 1.

A series of binary-weighted capacitors 110, 108, 106, 104, ... 102 have capacitance values or weights of 64, 32, 16, 8, 4, 2, and 1 times a minimum capacitor value of C, C1 capacitor 102. All of binary-weighted capacitors 110, 108, 106, 104, ... 102 have one terminal that connects to delay node D between inverters 92, 94, and another terminal connected to ground through enabling transistors 120, 118, 116, 114, ... 112. Bits in SAR register 130 drive the gates of enabling transistors 120, 118, 116, 114, ... 112. When the bit in SAR register 130 is high, the enabling transistor is turned on, connecting the lower terminal of the capacitor to ground, enabling the capacitor and increasing the capacitance and delay of delay node D.

For example, the value 1010000 programmed into SAR register 130 enables transistors 120, 116, and capacitors 110, 106, increasing the capacitance on delay node D by 64C + 16C, or 80C. MSB capacitor 110 adds a 64C delay while capacitor 106 adds a 16C delay. Other SAR delays 42, 43, 44 operate in a similar manner and can each be programmed with a different SAR delay value.

Figure 6 is a block diagram of a 3-channel interleaved ADC with details of the product derivative correlators that drive a matrix processor for calibration of programmable input delays. In this simplified 3-channel ADC, there are only three ADC 10, 12, 13, three sampling switches 20, 22, 23, three SAR delays 40, 42, 43, and three inputs D1, D2, D3 to mux 64, which operates with clock TSX3.

The three FIR filters 17 generate filtered digital values Y1, Y2, Y3 that are input to product derivative correlators 52-1, 52-2, and 52-3 for channels 1, 2, 3 that generate product derivative factors F1, F2, F3, respectively.

Channel 2 product derivative correlator 52-2 has sample delay 11 delay Y2 before being input to multiplier 142, where its is multiplied by the sum from adder 140, which is Y3 delayed by sample delay 148 minus Y1 delayed by sample delay 146. Averager 54 then generates the average over M analog-input samples to generate product derivative factor F2. Product derivative correlator 52-2 generates the function:

$$F2 = Average\{Y2[n\text{-}1] * (Y3[n\text{-}1] - Y1[n\text{-}1])\}$$

where n is the sample number, from 1 to N, and the average is over N samples. F2 is the average correlation of the current channel Y2 with its adjacent channels Y1, Y3. F2 is a product derivative correlation factor.

In general, for any channel X in an N-channel interleaved ADC,

$$F(X) = Average\{Y(X)[n\text{-}1] * (Y(X+1)[n\text{-}1] - Y(X\text{-}1)[n\text{-}1])\}$$

where X+1 and X-1 are performed modulo N, so that first channel 1 has Y(X-1) = Y(N) = Y3 input to sample delay 146, which delays by 2 samples ($Z^{-2}$) in product derivative correlator 52-1, while last channel 3 has Y(X+1) = Y(1) = Y1 input directly to adder 140, bypassing sample delay 148 in product derivative correlator 52-3. When modulo wrapping, the sample number is also increased or decreased by 1.

First channel (X=1) product derivative correlator 52-1 generates:

$$F(1) = Average\{Y(1)[n\text{-}1] * (Y(2)[n\text{-}1] - Y(N)[n\text{-}2])\}$$

since X-1 modulo N wraps back to N, the last channel.

Last channel (X=N) product derivative correlator 52-3 generates:

$$F(N) = Average\{Y(N)[n\text{-}1] * (Y(1)[n] - Y(N\text{-}1)[n\text{-}1])\}$$

since X+1 modulo N wraps forward to channel 1.

product derivative factors F1, F2, F3, F4 are combined and arranged into a matrix F:

$$F = \begin{bmatrix} F_1 \\ F_2 \\ \cdot \\ \cdot \\ \cdot \\ F_{N-1} \\ F_N \end{bmatrix} = \begin{bmatrix} \overline{Y_1[n-1](Y_2[n-1] - Y_N[n-2])} \\ \overline{Y_2[n-1](Y_3[n-1] - Y_1[n-1])} \\ \cdot \\ \cdot \\ \cdot \\ \overline{Y_{N-1}[n-1](Y_N[n-1] - Y_{N-2}[n-1])} \\ \overline{Y_N[n-1](Y_1[n] - Y_{N-1}[n-1])} \end{bmatrix}$$

The correlation matrix is based on the shift matrix C, which is a N x N-1 matrix with N rows and N-1 columns:

$$C = \begin{bmatrix} -1 & 0 & 0 & 0 & 0 & \ldots\ldots & 0 & 0 & -1 \\ 2 & -1 & 0 & 0 & 0 & \ldots\ldots & 0 & 0 & 0 \\ -1 & 2 & -1 & 0 & 0 & \ldots\ldots & 0 & 0 & 0 \\ 0 & -1 & 2 & -1 & 0 & \ldots\ldots & 0 & 0 & 0 \\ & & & & \vdots & & & & \\ 0 & 0 & 0 & 0 & 0 & \ldots\ldots & -1 & 2 & -1 \\ 0 & 0 & 0 & 0 & 0 & \ldots\ldots & 0 & -1 & 2 \end{bmatrix}$$

The correlation matrix is the transpose of C, $C^T$, divided by the product of the transpose of C, $C^T$, and C, or:

$$\frac{C^T}{C^T C} = INV(C^T C)C^T$$

Alternately, the inverse matrix INV of $(C^T * C)$ may be multiplied by $C^T$.

Matrix processor 50 generates the sign bits for channels 2 through N by multiplying matrix F by the correlation matrix:

$$([sign(2)\ sign(3)\ \ldots\ldots\ sign(N)]^T) = -sign\left(\frac{C^T}{C^T C} F\right)$$

Since the shift matrix C is a constant that only depends on its size N, the adjacent channel correlation results from product derivative factors [F1, F2, F3, ... FN] is a variable that is multiplied by a constant to generate the sign bits. Sign bits sign(2), sign(3), ...sign(N) form a 1-dimensional matrix or a vector, and can be transposed from a vertical 1 x N matrix to a horizontal N x 1 matrix for easier processing or data storage.

At the start of calibration SAR delay 40 is set with a fixed delay value, such as a mid-point value of 10000...0, while SAR delays 42, 43 have bits set and cleared by calibrator 55 during a SAR routine. When sign bit sign(2) generated by matrix processor 50 is high, calibrator 55 sets high the bit in SAR delay 42, but when sign bit sign(2) is low, calibrator 55 clears low the bit in SAR delay 42. Likewise, when sign bit sign(3) generated by matrix processor 50 is high, calibrator 55 sets high the bit in SAR delay 43, but when sign bit sign(3) is low, calibrator 55 clears low the bit in SAR delay 43.

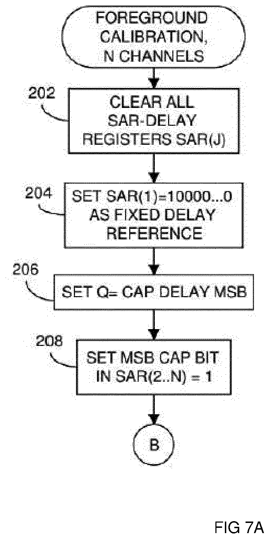

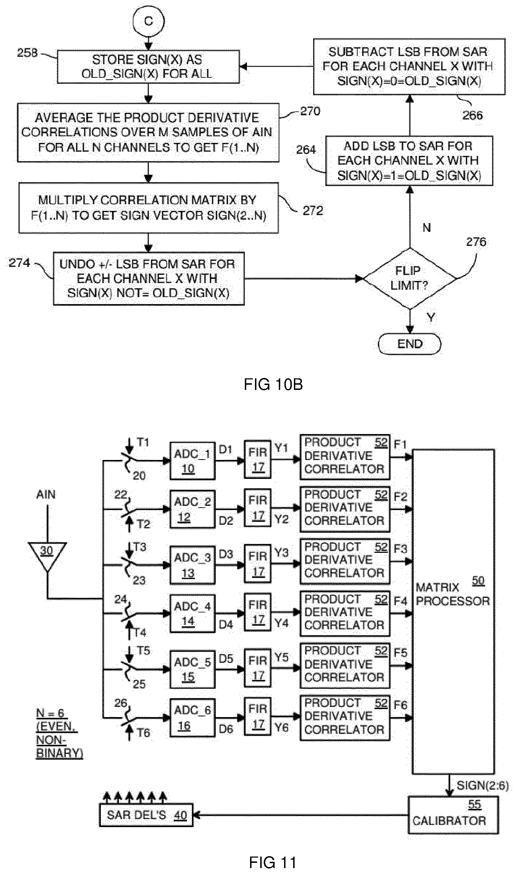

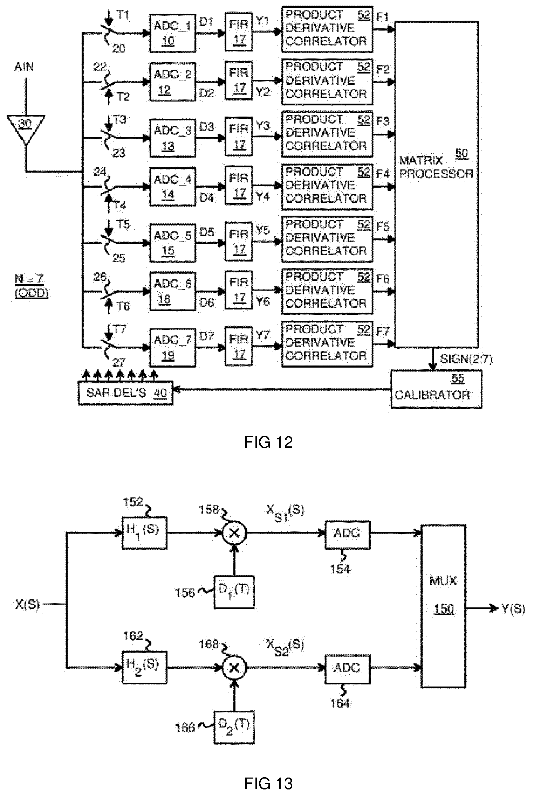

Figures 7A-7B is a flowchart of foreground calibration of N ADC channels interleaved together. This process can be used to initially calibrate the 4-way interleaved ADC of Fig. 4, the 3-way interleaved ADC of Fig. 6, the 6-way interleaved ADC of Fig. 11, the 7-way interleaved ADC of Fig. 12, or any arbitrary N-way interleaved ADC, where N is a whole number of at least 3.

All bits in all of SAR delay 40, 42, 43, 44 are cleared for initialization for all arbitrary channels J, SAR(J), step 202. SAR delay 40 for the first channel, SAR(1), is set to the midpoint value of 1000...0, step 204. The first channel acts as a fixed timing reference for correlation with the other channels, so SAR(1) remains fixed for the rest of foreground calibration. The other channels have bits in their SAR(J) set or cleared during calibration.

The current bit-position Q in SAR delays 42, 42, 44, SAR(J), is set to the MSB of the variable delay or variable capacitor, step 206. This MSB bit Q=MSB is set in SAR(J=2..N) for each of the remaining N-1 channels, step 208.

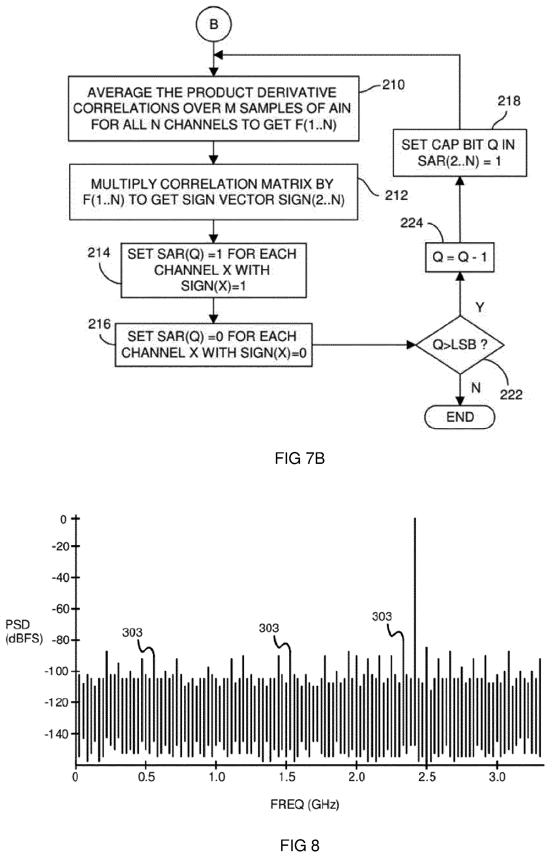

In Fig. 7B, product derivative correlators 52 generate product derivative factors F1, F2, F3, F4, ...FN that are each the average correlation to adjacent channels over M samples, step 210. Matrix processor 50 arranges product derivative factors F1, F2, F3, F4,...FN into a matrix F and multiples it by the correlation matrix, $C^T/(C^T*C)$, step 212. The result from matrix processor 50 is sign vector sign(2...N). This sign vector has one sign bit for each of channels 2 to N. Each sign bit indicates the sign of the correlated delay difference for that channel relative to the first channel.

When the sign bit for a channel X is 1, step 214, then calibrator 55 keeps SAR(Q) high for that channel. The added delay in SAR delay 42, 43, 44 was not large enough. SAR(Q) is the corresponding bit in SAR delay 42, 43, 44 for bit-position Q.

When the sign bit for a channel X is 0, step 216, then calibrator 55 clears SAR(Q) to 0 for that channel. The added delay in SAR delay 42, 43, 44 was too large.

When Q has not yet reached the LSB, step 222, then Q is decremented, step 224, and the next significant bit Q in SAR delay 42, 43, 44 is set, step 218. Next in step 210, product derivative correlators 52 generate new values of product derivative factors F1, F2, F3, F4,...Fn using the new delay values in SAR delay 42, 43, 44 set by calibrator 55 in step 218. Matrix processor 50 generates new sign bits, step 212, and calibrator 55 clears any bits that have zero sign bits, step 216.

This process repeats for successively smaller Q bit-positions and smaller added capacitances in steps 210-224 until Q reaches the LSB, step 222, when calibration ends.

Figure 8 is a graph of reduced spurious tones in a spectrum for an interleaved ADC with channel input delays calibrated by product derivative correlators and matrix processing. Sampling pulse-width mismatches and component mismatches that introduce non-linearities or errors are compensated for by the calibration routine of Figs. 7A-7B adjusting the programmable delays in SAR delay 40, 42, 43, 44 in the interleaved ADC shown in Fig. 4. This calibration reduces the amplitude of spurious tones 303. These spurious tones still occur at integer multiples of Fs/N, K*Fs/N $\pm$ Fin, where Fs is the sampling frequency (period Ts = 1/Fs) and N is the number of channels interleaved together. However, the amplitude of spurious tones 303 are reduced when compared with spurious tones 302 of the prior-art of Fig. 3.

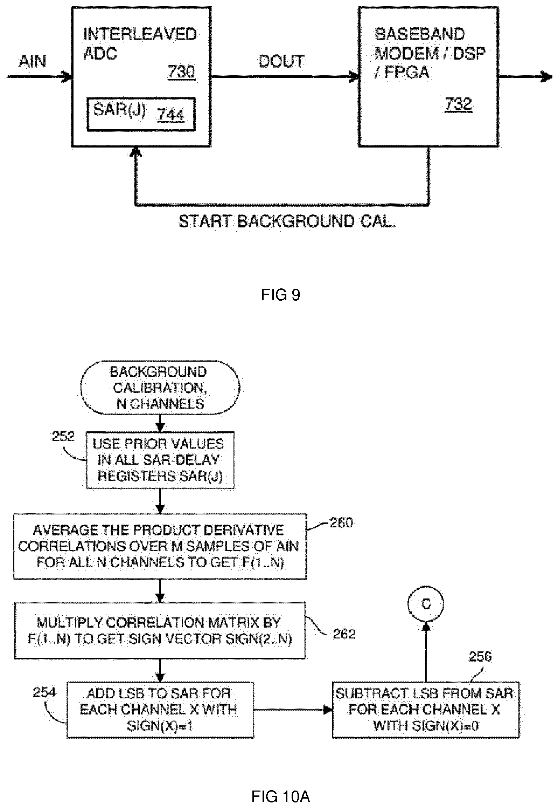

Figure 9 shows a backend processor triggering background calibration of an interleaved ADC. Foreground calibration, such as shown in Figs. 7A-7B, can be triggered on power-up, initialization, or a reset. This foreground calibration uses product derivative correlators and a matrix processor with calibrator 55 to perform Successive-Approximation searches that load delay values into SAR delay registers 744 in interleaved ADC 730 to compensate for timing skews among ADC channels in interleaved ADC 730.

Temperature and voltage conditions can drift over time. Switches, delays, ADCs, and other components and their errors can be temperature and voltage dependent. The circuitry in interleaved ADC 730 is sensitive to temperature and voltage. Over time, as the system heats up or as the environment changes, temperature and supply voltage changes may cause increased timing skews in interleaved ADC 730. As conditions drift, the calibrated delays may need to be updated to compensate for this drift. Background calibration can be triggered periodically to compensate for these drifts.

Downstream device 732 could be a baseband modem, a Digital Signal Processor (DSP), a Field-Programmable Logic Array (FPGA), or other device that uses the digital output DOUT from interleaved ADC 730. Downstream device 732 may include logic that detects when temperature, voltage, or other conditions have changed and trigger interleaved ADC 730 to perform background calibration. Downstream device 732 could have a timer and trigger background calibration after some period of time, such as hourly or daily. Downstream device 732 could detect idle times or times when the analog input AIN has a suitable signal strength and frequency for calibration. Pattern generation logic integrated with interleaved ADC 730 may also be enabled to generate suitable analog input AIN signals for calibration.

Figures 10A-10B show a flowchart of a background calibration process. Background calibration is performed after foreground calibration has completed and calibrated delays are loaded into all of SAR delay 40, 42, 43, 44,... SAR(J) and re-used, step 252.

Product derivative correlators 52 generate product derivative factors F1, F2, F3, F4, ...FN that are each the average correlation to adjacent channels over M samples, step 260. Matrix processor 50 arranges product derivative factors F1, F2, F3, F4,...FN into a matrix F and multiples it by the correlation matrix, $C^T/(C^T*C)$, step 262. The result from matrix processor 50 is sign vector sign(2...N). This sign vector has one sign bit for each of channels 2 to N.

When the sign bit for a channel X is 1, step 254, then calibrator 55 adds one LSB to the delay value in SAR delay 42, 43, 44 for that channel X. The added delay in SAR delay 42, 43, 44 was not large enough.

When the sign bit for a channel X is 0, step 256, then calibrator 55 subtracts one LSB from the SAR delay value SAR(X) for that channel. The added delay in SAR delay 42, 43, 44 was too large.

In Fig. 10B, the sign vector sign(2..N) is stored as the old sign vector old_sign(2..N), step 258. Product derivative correlators 52 again generate product derivative factors F1, F2, F3, F4, ...FN that are each the average correlation to adjacent channels over M samples, step 270. Matrix processor 50 once again arranges product derivative factors F1, F2, F3, F4,...FN into a matrix F and multiples it by the correlation matrix, $C^T/(C^T*C)$, step 272. The result from matrix processor 50 is the new sign vector sign(2...N).

When the sign bit for a channel X has changed, so that sign(X) is not equal to old_sign(X), step 274, then the LSB either added in step 254 or subtracted in step 256 is removed, such as by subtracting one LSB or adding one LSB, or by re-loading the prior value in SAR(X) before the last loop. A flip indicator for that channel X is incremented when the sign bit changes.

When a flip limit is not yet reached, step 276, then another loop begins. When the sign bit for a channel X is 1, and the old sign bit old_sign(X) was also 1, step 264, then calibrator 55 adds one LSB to the delay value in SAR delay 42, 43, 44 for that channel X.

When the sign bit for a channel X is 0, and the old sign bit old_sign(X) was also 0, step 266, then calibrator 55 subtracts one LSB from the SAR delay value SAR(X) for that channel. Then steps 258, 270, 272, 274 are repeated.

When a flip limit is reached, step 276, the background calibration process ends. The flip limit can be when each of the channels has flipped in each of the last FL loops or can require that the majority of the channels have flipped in each of the last FL loop, or to some other endpoint condition. For example, FL could be 20. When the endpoint is reached, each loop iteration successively adds and removes the LSB in each channel's SAR, indicating that a steady-state has been reached and further iterations do not result in better skew matching. The flip limit FL can be set to as little as 1, or to a larger value for better robustness.

The MSB is used for foreground calibration when large changes in delay are desirable to converge on the calibration result more rapidly. However, the LSB is used for background calibration, since the drift is not expected to be large, so slower adjustments are more desirable for background calibration.

Figure 11 shows a non-binary number of ADCs interleaved and calibrated with product derivative correlators and a matrix processor. While a binary number of channels is very efficient, there may be a non-binary number of ADC channels N. For example, there may be N=6 ADC channels that generate filtered outputs Y1, Y2, Y3, ... Y6 from FIR filters 17. Switches 20-26 sample the analog input to ADC 10-16, which are filtered by FIR filters 17 and drive six product derivative correlators 52. Six product derivative correlators 52 generate product derivative factors F1, F2, F3, F4, F5, F6 that form a matrix that is multiplied by the correlation matrix in matrix processor 50 to generate sign bit vector sign(2..6) that controls calibrator 55 adjusting delay values in SAR delay 40.

For N = 6 channels, F is:

$$F = \begin{cases} E[Y1[n-1](Y2[n-1]-Y6[n-2])] \\ E[Y2[n-1](Y3[n-1]-Y1[n-1])]] \\ E[Y3[n-1](Y4[n-1]-Y2[n-1])]] \\ E[Y4[n-1](Y5[n-1]-Y3[n-1])]] \\ E[Y5[n-1](Y6[n-1]-Y4[n-1])]] \\ E[Y6[n-1](Y1[n]-Y5[n-1])]] \end{cases}$$

The correlation matrix is $C^T/(C^T * C)$, where C is:

$$C = \begin{bmatrix} -1 & 0 & 0 & 0 & -1 \\ 2 & -1 & 0 & 0 & 0 \\ -1 & 2 & -1 & 0 & 0 \\ 0 & -1 & 2 & -1 & 0 \\ 0 & 0 & -1 & 2 & -1 \\ 0 & 0 & 0 & -1 & 2 \end{bmatrix}$$

Other non-binary even values of N could be substituted and the system adjusted as needed.

Figure 12 shows a non-binary odd number of ADCs interleaved and calibrated with product derivative correlators and a matrix processor. In this alternative, there are and odd number N=7 ADC channels that generate filtered outputs Y1, Y2, Y3, ... Y7. Switches 20-27 sample the analog input to ADC 10-16, 19, which are filtered by FIR filters 17 and drive seven product derivative correlators 52.

Seven product derivative correlators 52 generate product derivative factors F1, F2, F3, F4, F5, F5, F6, F7 that form a matrix that is multiplied by the correlation matrix in matrix processor 50 to generate sign bit vector sign(2..7) that controls calibrator 55 adjusting delay values in SAR delay 40.

For N = 7 channels, F is:

$$F = \begin{cases} E[Y1[n-1](Y2[n-1]-Y7[n-2])] \\ E[Y2[n-1](Y3[n-1]-Y1[n-1])]] \\ E[Y3[n-1](Y4[n-1]-Y2[n-1])]] \\ E[Y4[n-1](Y5[n-1]-Y3[n-1])]] \\ E[Y5[n-1](Y6[n-1]-Y4[n-1])]] \\ E[Y6[n-1](Y7[n-1]-Y5[n-1])]] \\ E[Y7[n-1](Y1[n]-Y6[n-1])]] \end{cases}$$

the correlation matrix is $C^T/(C^T * C)$, where C is:

$$C = \begin{bmatrix} -1 & 0 & 0 & 0 & 0 & -1 \\ 2 & -1 & 0 & 0 & 0 & 0 \\ -1 & 2 & -1 & 0 & 0 & 0 \\ 0 & -1 & 2 & -1 & 0 & 0 \\ 0 & 0 & -1 & 2 & -1 & 0 \\ 0 & 0 & 0 & -1 & 2 & -1 \\ 0 & 0 & 0 & 0 & -1 & 2 \end{bmatrix}$$

Other odd non-binary values of N could be substituted and the system adjusted as needed.

Mathematical Derivation of Matrix Formulas

Shown below is a mathematical derivation of the formulas implemented by product derivative correlators 52 and matrix processor 50 to generate the sign bit vector used for the SAR routine decisions.

An autocorrelation function is defined as:

$$R = E[Yi[n]Yj[n]]$$

Herein $\Delta T_i$ denotes the timing skew mismatch in a channel i relative to a reference channel. If $\Delta T_1, \Delta T_2, \Delta T_3, \Delta T_4$ are small compared to Ts, then 1st order Taylor Series can be approximated as

$$E[Y1[n]Y1'[n]] = E[Y1[nTs + \Delta T_1](Y2[nTs + \Delta T_2] - Y4[(n-1)nTs + \Delta T_4])]$$

$$\approx R_Y(Ts + \Delta T_2 - \Delta T_1) - R_Y(Ts - \Delta T_4 + \Delta T_1)$$

$$\approx (\Delta T_2 - \Delta T_1)\frac{\partial R_Y}{\partial \tau} - (-\Delta T_4 + \Delta T_1)\frac{\partial R_Y}{\partial \tau}$$

$$= (-2\Delta T_1 + \Delta T_2 + \Delta T_4)\frac{\partial R_Y}{\partial \tau}$$

$$= -[2 \quad -1 \quad 0 \quad -1][\Delta T_1 \; \Delta T_2 \; \Delta T_3 \; \Delta T_4]^T \frac{\partial R_Y}{\partial \tau}$$

For 4 channel, we can generalize the following product derivative vectors

$$F = \begin{cases} E[Y1[n]Y1'[n]] \\ E[Y2[n]Y2'[n]] \\ E[Y3[n]Y3'[n]] \\ E[Y4[n]Y4'[n]] \end{cases}$$

A Matrix C for timing skew error is generalized as

$$C = \begin{bmatrix} 2 & -1 & 0 & -1 \\ -1 & 2 & -1 & 0 \\ 0 & -1 & 2 & -1 \\ -1 & 0 & -1 & 2 \end{bmatrix}$$

Therefore, all related to this equation

$$F = -C[\Delta T_1 \ \Delta T_2 \ \Delta T_3 \ \Delta T_4]^T \frac{\partial R_Y}{\partial \tau}$$

To solve this equation, we need to fix one timing skew error to be zero by removing first column of C

$$C = \begin{bmatrix} -1 & 0 & -1 \\ 2 & -1 & 0 \\ -1 & 2 & -1 \\ 0 & -1 & 2 \end{bmatrix}$$

Without loss of generality, vector $\Delta$T can be resolved as

$$[\Delta T_2 \ \Delta T_3 \ \Delta T_4]^T = -\frac{1}{\frac{\partial R_Y}{\partial \tau}} \frac{C^T}{C^T C} F$$

The sign value of the above equation provides the calibration direction to converge min. vector $\Delta$T

$$sign([\Delta T_2 \ \Delta T_3 \ \Delta T_4]^T) = -sign\left(\frac{1}{\frac{\partial R_Y}{\partial \tau}} \frac{C^T}{C^T C} F\right)$$

Since derivative of autocorrelation has fixed polarity over Nyquist bandwidth, then we can simply the calibration

equation into

$$sign([\Delta T_2 \ \Delta T_3 \ \Delta T_4]^T) = -sign\left(\frac{C^T}{C^T C}F\right)$$

Theoretical Model of Interleaved ADC

Figure 13 shows a model of an interleaved ADC. An analog input X(S) is sampled by first sampler 152 as function $H_1(S)$, which is multiplied by first multiplier 158 with first delay 156 $D_1(T)$ to generate $X_{S1}(S)$ that is input to first ADC 154. In the second channel, analog input X(S) is also sampled by second sampler 162 as function $H_2(S)$, which is multiplied by second multiplier 168 with second delay 166 $D_2(T)$ to generate $X_{S2}(S)$ that is input to second ADC 164. The digital outputs of first ADC 154 and second ADC 164 are muxed together by mux 150 to generate output Y(S).

The following equations and discussion are presented as a theoretical background and is not intended to limit the invention or its claims but are presented for edification.

Assuming a single-pole sampling system, sampled analog signal (odd) and (even) are given by:

$$X_{S1}(s) = H_1(s) \times \left[\frac{1}{T_s}\sum_{k=-\infty}^{\infty} X\left(j\left(\omega - \frac{2\pi k}{T_s}\right)\right)\right]$$

$$X_{S2}(s) = H_2(s) \cdot e^{-j2\pi k\frac{\Delta T}{T_s}} \times \left[\frac{1}{T_s}\sum_{k=-\infty}^{\infty} X\left(j\left(\omega - \frac{2\pi k}{T_s}\right)\right)\right]e^{-jk\pi}$$

Therefore, digital output Y(s) is given by:

$$Y(s) = X_{S1}(s) + X_{S2}(s)$$

$$= \left[\frac{1}{T_s}\sum_{k=-\infty}^{\infty} X\left(j\left(\omega - \frac{2\pi k}{T_s}\right)\right)\right] \times \left[H_1(s) + e^{-jk\pi}H_2(s)\cdot e^{-j2\pi k\frac{\Delta T}{T_s}}\right]$$

Ideally, if $H_1(s) = H_2(s) = H(s)$ and $\Delta T = 0$, then

$$Y_{ideal}(s) = \frac{1}{T_S'}\sum_{n=-\infty}^{\infty} X\left(j\left(\omega - \frac{2\pi n}{T_S'}\right)\right) \quad where \ T_S' = \frac{T_S}{2}$$

Odd image replica from $H_2(s)$ is well-cancelled with $H_1(s)$, in other words, bandwidth of X(s) could be double due to ping-pong sampling system as expected. However, error image (i.e. uncorrected odd image replica) exists in reality due to $H_1(s) \neq H_2(s)$ if $\Delta T \neq 0$.

Herein, we would like to approximate the error due to finite bandwidth mismatch and timing skew as below:

$$Y(s) = Y_{ideal}(s) + E_Y(s)$$

$$= Y_{ideal}(s) + Y_{ideal}(s) \times \left[ H_1(s) - H_2(s) \cdot e^{-j2\pi m \frac{\Delta T}{T_s}} \right]$$

where m is odd #.

This provides the basis analysis on the effect of "dynamic error" in the proposed ADC system. Our target is to evaluate the frequency response of E(s), basically, exponential term can be generalized into:

$$e^{-j2\pi \frac{\Delta T}{T_s}} \rightarrow e^{-s\Delta T}$$

Consequently, equivalent frequency response of two sampling systems converges into

$$E(s) = H_1'(s) - H_2'(s)$$

Consider the case in ping-pong sampling with mismatches, we have the following:

$$H_1'(s) = \frac{1}{1 + \dfrac{s}{\omega_o}}$$

$$H_2'(s) = \frac{e^{-s\Delta T}}{1 + \dfrac{s}{\omega_o + \Delta\omega}}$$

where $\Delta t$ denotes the timing skew mismatch in channel 2 relative to channel 1, $\Delta\omega$ denotes the finite bandwidth mismatch in channel 2 relative to channel 1.

Equivalently, it becomes:

$$H_1'(s) = \frac{1}{1 + \dfrac{s}{\omega_o}}$$

and

$$H_2'(s) = \frac{e^{-s\Delta T}}{1 + \dfrac{s}{\omega_o(1 + \dfrac{\Delta\omega}{\omega_o})}}$$

Herein, we exclude the effect of gain mismatches on $H_1'$(s) and $H_2'$(s) because it is not input freq. dependent if cross products terms are negligible compared to fundamental terms.

Consider the "Dynamic Error" *E(s),* i.e.

$$E(s) = H_1'(s) - H_2'(s)$$

Equivalently, neglecting cross product terms, it becomes:

$$E(s) \approx -\left(\frac{\omega_o}{s+\omega_n}\right)\left[\frac{s}{s+\omega_n}\frac{\Delta\omega}{\omega_n} - \left(1+\frac{\Delta\omega}{\omega_n}\right)s\Delta T\right]$$

$$\approx -\left(\frac{1}{1+\frac{s}{\omega_o}}\right)\left[s\underbrace{\left(\frac{1}{1+\frac{s}{\omega_o}}\right)\left(\frac{1}{\omega_o}\right)\left(\frac{\Delta\omega}{\omega_o}\right)}_{E_{bw}(s)} - \underbrace{s\Delta T}_{E_{sk}(s)}\right]$$

$E_{bw}(s)$ and $E_{sk}(s)$ account the effect of finite bandwidth and timing-skew mismatches, respectively.

Clearly, if both $\Delta\omega = 0$ and $\Delta T = 0$, dynamic errors caused by finite bandwidth mismatch and timing skew is zero, respectively.

However, dynamic error always exists and therefore calibration is required to fulfill the target performance. As a result, the time derivatives for the dynamic error is of interest in our case. Consider the following:

$$E_{sk}(s) \approx \frac{s\Delta t}{1+\frac{s}{\omega_o}} = \left[s - s\left(\frac{s}{\omega_o}\right) + s\left(\frac{s}{\omega_o}\right)^2 - s\left(\frac{s}{\omega_o}\right)^3 + \cdots\right]\Delta T$$

$$E_{bw}(s) \approx -s\left(\frac{1}{1+\frac{s}{\omega_o}}\right)^2\left(\frac{\Delta\omega}{\omega_o}\right)\left(\frac{1}{\omega_o}\right)$$

$$= -\left[\left(\frac{s}{\omega_o}\right) - 2\left(\frac{s}{\omega_o}\right)^2 + 3\left(\frac{s}{\omega_o}\right)^3 - 4\left(\frac{s}{\omega_o}\right)^4 + \cdots\right]\left(\frac{\Delta\omega}{\omega_o}\right)$$

By taking "Inverse Laplace Transform" back to time domain, we have:

$$e_{sk}(t) \approx \left(\frac{\partial Y}{\partial t} - \frac{1}{\omega_o}\frac{\partial^2 Y}{\partial t^2} + \frac{1}{\omega_o^2}\frac{\partial^3 Y}{\partial t^3} - \frac{1}{\omega_o^3}\frac{\partial^4 Y}{\partial t^4} + \cdots\right)\Delta T$$

$$e_{bw}(t) \approx -\left(\frac{1}{\omega_o}\frac{\partial Y}{\partial t} - \frac{2}{\omega_o^2}\frac{\partial^2 Y}{\partial t^2} + \frac{3}{\omega_o^3}\frac{\partial^3 Y}{\partial t^3} - \frac{4}{\omega_o^4}\frac{\partial^4 Y}{\partial t^4} + \cdots\right)\left(\frac{\Delta\omega}{\omega_o}\right)$$

From equations above, $Y(s) = Y_{ideal}(S) \cdot H(s) = X(s) \cdot H(s)$ (i.e. filtered analog input signal).

Since H(s) is a desired response of loop filter common to ping-pong channels, the above equation is also identical to:

$$e_{sk}(t) \approx \left(\frac{\partial x}{\partial t} - \frac{1}{\omega_o}\frac{\partial^2 x}{\partial t^2} + \frac{1}{\omega_o^2}\frac{\partial^3 x}{\partial t^3} - \frac{1}{\omega_o^3}\frac{\partial^4 x}{\partial t^4} + \cdots\right)\Delta T$$

$$e_{bw}(t) \approx -\left(\frac{1}{\omega_0}\frac{\partial x}{\partial t} - \frac{2}{\omega_0^2}\frac{\partial^2 x}{\partial t^2} + \frac{3}{\omega_0^3}\frac{\partial^3 x}{\partial t^3} - \frac{4}{\omega_0^4}\frac{\partial^4 x}{\partial t^4} + \cdots\right)\left(\frac{\Delta\omega}{\omega_0}\right)$$

Notice that the effect of H(s) introduces finite gain error and phase shift according to input signal freq. that doesn't contribute odd image replica but the mismatch on two sampling systems.

In time domain, an earlier equation is converged linearly into:

$$y(t) = y_{ideal}(t) + e(t) = x(t) + e_{bw}(t) + e_{sk}(t)$$

Consider the absolute dynamic error signal e(t),

$$e(t) \approx -\left[\left(\Delta T + \tau_{SAMP}\frac{\Delta\omega}{\omega_0}\right)\frac{\partial x}{\partial t} - \left(\Delta T + 2\tau_{SAMP}\frac{\Delta\omega}{\omega_0}\right)\tau_{SAMP}\frac{\partial^2 x}{\partial t^2} + \left(\Delta T + 3\tau_{SAMP}\frac{\Delta\omega}{\omega_0}\right)\tau_{SAMP}^2\frac{\partial^3 x}{\partial t^3} + \cdots\right]$$

For instance, if $\Delta T = +/-1ps$, $\tau_{SAMP} = 1/(2*\pi*5G) = 32ps$ and $\Delta\omega/\omega_0 = 1\%$, first order error term is bounded by +/- 1.064ps (in modern multi-GS/s ADC).

From the equation above, both $\Delta T$ and $\Delta\omega/\omega_0$ are somewhat related to signal/clock/component mismatches that could be reduced by properly layout and physical component sizing whereas $\tau_{SAMP}$ is circuit design parameter (PVT var.).

To mitigate the effect of dynamic errors, linearity performance (interleaving spur) can be reduced by design of a wider sampling bandwidth (lower $\tau_{SAMP}$) that tradeoff fundamentally with noise, power and other circuit design physical constraints.

From the above equation, it can be generalized into a Taylor Series Expansion error signal:

$$e(t) \approx -\left(\Delta t_1\frac{\partial x}{\partial t} - \Delta t_2\frac{\partial^2 x}{\partial t^2} + \Delta t_3\frac{\partial^3 x}{\partial t^3} - \Delta t_4\frac{\partial^4 x}{\partial t^4} + \cdots\right)$$

Consider a single carrier signal $x(t) = A\sin(\omega t)$, odd and even time derivatives are given by:

$$\frac{\partial x}{\partial t} = A\omega \cdot \cos(\omega t) \qquad \frac{\partial^2 x}{\partial t^2} = -A\omega^2 \cdot \sin(\omega t) \qquad \frac{\partial^3 x}{\partial t^3} = -A\omega^3 \cdot \cos(\omega t)$$

Error signal is proportional to amplitude A and Frequency of signal.

Error signals appear at 90deg, 180deg, 270deg and so on (i.e. integer*Fs/2 $\pm$ Fin) -> spurious tones. Both sampling pulse and finite bandwidth mismatches appear as pulse width difference error among channels. Therefore, it is possible to cancel it by adjusting the sampling pulse width via variable delay elements before samplers to align their effective sampling pulse width.


ALTERNATE EMBODIMENTS

Several other embodiments are contemplated by the inventors. For example, clocks may be derived from other clocks and thus synchronized. Clocks may be buffered, enabled, and qualified by logic. The analog input signal may be buffered in a variety of ways and buffer arrangements or trees. While initial clearing of all bits in all SARs has been described, the SAR bits could all be initially cleared to a high state rather than to a low state. Active-low rather than active-high bit could be used.

All matrixes could be rotated or transposed, or otherwise operated upon so that columns become rows and rows become columns. Thus, the terms row and column could be interchanged.

Binary-weighted capacitors 110, 108, 106, 104, ... 102 could be connected to the power-supply or to some other voltage rather than to ground. These capacitors may be enabled by p-channel or n-channel transistors, and the bits stored in SAR delay 40 may be active-high or active-low, and these bits may be encoded in various ways and need to be decoded by a decoder in SAR delay 40. While binary-weighted capacitors 110, 108, 106, 104, ... 102 have been shown, these capacitors could have other weight sequences, such as 1C, 1C, 2C, 5C, 11C, 15C, etc., and the Successive-Approximation-Register (SAR) programming could be adjusted for these non-binary sequence of weights. Rather than having binary-weighted capacitors 110, 108, 106, 104, ... 102, SAR delay 40 could employ other weighted delay elements, such as resistors, transistors or buffers of various sizes or weights. While binary-weighted capacitors have been described, other weightings could be substituted, such as decimally-weighted, prime-weighted, or linearly-weighted, or octal-weighted. The digital delay value in the SAR could be in these other number systems, such as octal numbers rather than binary numbers. Other kinds of delay elements could be substituted, such as parallel current sources, resistors, or various combinations, and in parallel, serial, or combined network arrangements. Values may be shifted, transformed, or processed in a variety of ways.

While product derivative correlator 52 has been shown for a particular midpoint correlation, other correlation functions could be substituted and product derivative correlator 52 adjusted to perform these substitute correlation functions. Inversions and complements may be added at various locations. Switches 20, 22, 23, 24 may be simple transistor switches, pass transistors, transmission gates, or other kinds of switches. Sample delay 11, 146, 148 may be implemented as a latch or other storage element or as a delay with combinational logic including NAND, NOR, XOR, XNOR gates. Rather than use capacitors for delay elements, MOSFETs, FinFETs, or other devices, either p-channel or n-channel, driven to power or ground, may be used as delay elements.

While the first channel's SAR delay 40 has been described in step 204 as being initialized to the midpoint value of 1000..0, a different channel could be initialized, or the initial value could be another value, such as 0100..0, 0010..0, etc. Any channel could act as the fixed timing reference, and the timing delay of that fixed reference could be any value.

Matrix processor 50 may use a Digital Signal Processor (DSP) or other processor that is efficient when performing matrix operations. Product derivative correlators 52 may be implemented in hardware and in parallel for high-speed calibration. Various combinations of hardware, firmware, and software may be used in these implementations and for calibrator 55.

FIR filters 17 can act as lowpass or bandpass filters for calibration, as long as the polarity of its correlation derivatives is known. FIR filtering can help define the polarity of its correlation derivatives to a well-defined value or specification to calibrate the interleaved ADC for a known frequency range. Since correlation derivatives are frequency dependent, FIR filtering can prevent any potential convergence problems during calibration.

Sample delays 11, 146, 148 each could be reduced by 1 sample delay period for very fast logic that does not require pipelining to meet timing requirements. Alternately, these sample delays could be increased by 1 or more samples for very fast pipelined systems with slow logic delays.

While some operations have been described in a parallel manner for faster processing, serial operation may be used. When performed serially, a single instance of product derivative correlator 52 could be used rather than separate instances of product derivative correlator 52 in the hardware. While a bank of N product derivative correlators 52 have been shown, product derivative correlators 52 could be re-used or operate in various series and parallel arrangements.

The process steps could be performed serially, or some steps may be performed in parallel. Various sequences may be adjusted or modified. Higher-level operations may be performed in software or firmware, such as SAR testing and decision logic, while lower-level functions may be performed in hardware, such as using product derivative correlator 52 to generate product derivative factors F1, F2, F3, F4. Some or all of the calibration routine could be replaced with hardware such as programmable logic, FPGA, or other logic gates on an Integrated Circuit (IC) or another chip. Various combinations of hardware, software, firmware, etc. may be substituted.

Product derivative correlators could operate upon more than 3 inputs as another alternative. Analog input buffers could be rearranged, so that one analog input buffer drives 4 or 2 ADCs, or there may be a tree structure of analog input buffers with multiple levels.

The number of samples averaged M could be different for foreground and background calibration and could even differ for different capacitor bit-positions, such as more samples for LSB's that are more sensitive and fewer samples for MSBs. M could also differ for other reasons such as varying voltage or temperature conditions.

The analog input signal AIN does not have to be a sine wave, but could be other forms of AC signals, such as a triangular wave, sine waves of different frequencies that are superimposed, or any wireless baseband signal. When the polarity of the correlation derivative can be determined, these signals may be used as input signals for calibration.

Averaging of the product derivative factors F1, F2, F3, F4 could be performed by setting a flip-flop when the sign bit is 1 and clearing the flip-flop when the sign bit is 0 for the current sum.

A flip limit FL may be used for ending background calibration when incrementing the LSB keeps flipping sign bits more than the FL times. Alternately, background calibration can end when the sign bits first flip.

The number of channels N can be binary, non-binary, even or odd. While 4 channel interleaving has been shown in detail, 8-channel, 7-channel, 6-channel, 16-channel, 32-channel, or N-channel interleaved ADC's may be substituted. The interleave order of the channels may be changed. Interleaving may be nested or may be one long loop at level 1.

Additional components may be added at various nodes, such as resistors, capacitors, inductors, transistors, etc., and parasitic components may also be present. Enabling and disabling the circuit could be accomplished with additional transistors or in other ways. Pass-gate transistors or transmission gates could be added for isolation. Inversions may be added, or extra buffering. Capacitors may be connected together in parallel to create larger capacitors that have the same fringing or perimeter effects across several capacitor sizes. Switches could be n-channel transistors, p-channel transistors, or transmission gates with parallel n-channel and p-channel transistors, or more complex circuits, either passive or active, amplifying or non-amplifying.

The number of ADC digital bits may be adjusted. For example, a 15 bit ADC could be used, or an 8-bit, 6-bit, 22-bit, or 18-bit. A different number of bits could be substituted for a different precision, and the number of bits could be fixed or could be variable.

The background of the invention section may contain background information about the problem or environment of the invention rather than describe prior art by others. Thus, inclusion of material in the background section is not an admission of prior art by the Applicant.

Any methods or processes described herein are machine-implemented or computer-implemented and are intended to be performed by machine, computer, or other device and are not intended to be performed solely by humans without such machine assistance. Tangible results generated may include reports or other machine-generated displays on display devices such as computer monitors, projection devices, audio-generating devices, and related media devices, and may include hardcopy printouts that are also machine-generated. Computer control of other machines is another tangible result.

Any advantages and benefits described may not apply to all embodiments of the invention. When the word "means" is recited in a claim element, Applicant intends for the claim element to fall under 35 USC Sect. 112, paragraph 6. Often a label of one or more words precedes the word "means". The word or words preceding the word "means" is a label intended to ease referencing of claim elements and is not intended to convey a structural limitation. Such means-plus-function claims are intended to cover not only the structures described herein for performing the function and their structural equivalents, but also equivalent structures. For example, although a nail and a screw have different structures, they are equivalent structures since they both perform the function of fastening. Claims that do not use the word "means" are not intended to fall under 35 USC Sect. 112, paragraph 6. Signals are typically electronic signals but may be optical signals such as can be carried over a fiber optic line.

The foregoing description of the embodiments of the invention has been presented for the purposes of illustration and description. It is not intended to be exhaustive or to limit the invention to the precise form disclosed. Many modifications and variations are possible in light of the above teaching. It is intended that the scope of the invention be limited not by this detailed description, but rather by the claims appended hereto.

## Claims

1. A matrix-calibrated interleaved Analog-to-Digital Converter (ADC) comprising:

   a plurality of N channels, wherein N is a whole number of at least 4, wherein each of the plurality of N channels comprises:
   an ADC (10, 12, 13, 14) that is configured to convert a sampled analog input into a digital output (D1, D2, D3, D4) having a digital value representing the sampled analog input;
   an analog switch (20, 22, 23, 24) that is configured to sample an analog input (AIN) receiving an AC signal in response to a delayed clock (T1, T2, T3, T4);
   a Successive-Approximation-Register, SAR, that is configured to be programmed with a delay value during calibration;
   a variable delay element (40, 42, 43, 44) having a variable delay that is controlled by the delay value stored in the SAR, the variable delay element configured for delaying an input sampling clock (TS1, TS2, TS3, TS4) by the variable delay to generate the delayed clock (T1, T2, T3, T4); to the analog switch;
   a product derivative correlator (52) that is configured to correlate the digital output (T1, T2, T3, T4) of a channel to the digital output (T1, T2, T3, T4) of adjacent channels in the plurality of channels to generate a product derivative factor (F1, F2, F3, F4) for the channel; and
   a matrix processor (50) that is configured to receive the product derivative factor (F1, F2, F3, F4) for each of the plurality of N channels to form a first matrix with N elements arranged in N rows with one element per row, each element having a value of the product derivative factor generated by the product derivative correlator for one of the N channels, the matrix processor is configured to multiply the first matrix with a correlation matrix to generate a sign matrix having N-1 elements that are each a correlation sign for N-1 of the plurality of N channels;
   wherein the correlation matrix is generated from a shift matrix C that is a matrix having N rows and N-1 columns in a format of:

$$C = \begin{bmatrix} -1 & 0 & 0 & 0 & 0 & \ldots\ldots & 0 & 0 & -1 \\ 2 & -1 & 0 & 0 & 0 & \ldots\ldots & 0 & 0 & 0 \\ -1 & 2 & -1 & 0 & 0 & \ldots\ldots & 0 & 0 & 0 \\ 0 & -1 & 2 & -1 & 0 & \ldots\ldots & 0 & 0 & 0 \\ & & & \vdots & & & & & \\ 0 & 0 & 0 & 0 & 0 & \ldots\ldots & -1 & 2 & -1 \\ 0 & 0 & 0 & 0 & 0 & \ldots\ldots & 0 & -1 & 2 \end{bmatrix} ;$$

wherein a transpose matrix CT is a transpose of the shift matrix C;

wherein the correlation matrix is the transpose matrix CT, divided by a first product matrix, wherein the first product matrix is the transpose matrix CT multiplied by the shift matrix C;

wherein the SAR is configured to be programmed with the delay values to compensate for timing skews among the plurality of N channels using a Successive-Approximation calibration routine that examines the correlation sign in the sign matrix to determine when to accept or reject trial bits in the SAR of a channel corresponding to the correlation sign in the sign matrix;

wherein the product derivative correlator (52) for a current channel comprises:

a first sample delay (11) that is configured to delay the digital output (D1, D2, D3, D4) of the current channel by one pulse of a sample clock to generate a first delayed sample;

a second sample delay (148) that is configured to delay the digital output (D1, D2, D3, D4) of a first adjacent channel to the current channel to generate a second delayed sample;

a third sample delay (146) that is configured to delay the digital output (D1, D2, D3, D4) of a second adjacent channel to the current channel to generate a third delayed sample;

a modulo wrap adjustor, that is configured to adjust the third sample delay (146) to delay the digital output (D1, D2, D3, D4) of the second adjacent channel relative to the current channel by two pulses of the sample clock to generate the third delayed sample when the current channel is a first channel (1) and the second adjacent channel is a last channel (N) in the plurality of N channels;

wherein the modulo wrap adjustor is also configured to adjust the second sample delay (148) to delay the digital output (D1, D2, D3, D4) of the first adjacent channel relative to the current channel by zero pulses of the sample clock to generate the second delayed sample when the current channel is the last channel (N) in the plurality of N channels and the first adjacent channel is the first channel (1) in the plurality of N channels;

wherein the first adjacent channel and the second adjacent channel are in the plurality of N channels;

a first adder (140) that is configured to subtract the third delayed sample from the second delayed sample to generate a first sum;

a first multiplier (142) that is configured to multiply the first sum by the first delayed sample to generate a first product; and

a Successive-Approximation calibrator (55), that is configured, for each correlation sign in the sign matrix:

(a) to add a test bit-position to the SAR of a channel having a corresponding correlation sign in the sign matrix having a value of 1;

(b) to subtract the test bit-position to the SAR of the channel having the corresponding correlation sign in the sign matrix having a value of 0;

and to repeat from (a) for successively smaller bit-positions in the SAR,

whereby the correlation sign in the sign matrix is used to add or subtract successive bit-positions in the SAR;

wherein the Successive-Approximation calibrator is configured to set the SAR for a reference channel in the plurality of channels to a fixed value;

wherein the Successive-Approximation calibrator is configured to not adjust the fixed value in the SAR of the reference channel, the Successive-Approximation calibrator adjusting the SAR for N-1 channels of the plurality of N channels;
wherein the product derivative correlator (52) further comprises:

an average generator (54) that is configured to average the first product over a plurality of M samples of the analog input to generate the product derivative factor as an averaged product derivative factor,
wherein M is a whole number.

2. The matrix-calibrated interleaved ADC of claim 1 wherein the product derivative correlator in each channel further comprises:
a Finite-Impulse-Response (FIR) filter that filters the digital output from the ADC, wherein the digital output input is a filtered digital output.

3. The matrix-calibrated interleaved ADC of claim 2 wherein N is not a power of two.

4. The matrix-calibrated interleaved ADC of claim 2 wherein N is an odd number.

5. The matrix-calibrated interleaved ADC of claim 2 wherein the digital output from the ADC is at least 6 bits.

6. The matrix-calibrated interleaved ADC of claim 1 wherein the variable delay element comprises a plurality of binary-weighted capacitors that are each enabled by a bit in the SAR.

7. The matrix-calibrated interleaved ADC of claim 1 further comprising:

a background calibration routine activated to adjust settings in the SARs that were previously set by calibration, the background calibration routine comprising:

(a) for each channel:

the background calibration routine configured for inputting the ADC digital outputs from a current channel and from a prior adjacent channel and from a next adjacent channel to a product derivative correlator that generates a sampled product derivative factor that quantifies correlation of the ADC digital output of the current channel to the ADC digital output of prior adjacent channel and the ADC digital output of the next adjacent channel;
the background calibration routine configured for averaging the sampled product derivative factor over multiple samples of the analog input to generate a product derivative factor for the current channel;

the background calibration routine configured for arranging the product derivative factors for all channels into a factor matrix;
the background calibration routine configured for multiplying the factor matrix by a correlation matrix to generate a sign matrix having N-1 sign bits corresponding to channels 2 to N;
for all channels except the reference channel:

(b) the background calibration routine configured for adding a Least-Significant Bit (LSB) test bit at a LSB bit-position in the SAR of a selected channel to adjust the delay value when the sign bit in the sign matrix corresponding to the selected channel is 1 and when the sign bit from a prior iteration was 1;
(c) the background calibration routine configured for subtracting the LSB test bit at the LSB bit-position in the SAR of a selected channel to adjust the delay value when the sign bit in the sign matrix corresponding to the selected channel is 0 and when the sign bit for a prior iteration was 0;

the background calibration routine configured for repeating from (a) until an endpoint is reached.

8. The matrix-calibrated interleaved ADC of claim 1 wherein all product derivative correlators are configured to be operated in parallel to calibrate the N channels in parallel.

9. The matrix-calibrated interleaved ADC of claim 1 wherein multiple product derivative correlators are configured to be processed serially by re-using a product derivative correlator in form of hardware.

**Patentansprüche**

1. Matrixkalibrierter verschachtelter Analog-DigitalWandler (ADC), umfassend:
eine Vielzahl von N Kanälen, wobei N eine Ganzzahl von mindestens 4 ist, wobei jeder der Vielzahl von N Kanälen Folgendes umfasst:

einen ADC (10, 12, 13, 14), der konfiguriert ist, eine geprobte analoge Eingabe in eine digitale Ausgabe (D1, D2, D3, D4) umzuwandeln, die einen digitalen Wert aufweist, der die geprobte analoge Eingabe repräsentiert;
einen Analogschalter (20, 22, 23, 24), der konfiguriert ist, eine analoge Eingabe (AIN) zu proben, der ein AC-Signal als Antwort auf einen verzögerten Takt (T1, T2, T3, T4) empfängt;
ein Register mit sukzessiver Annäherung, SAR, das konfiguriert ist, während der Kalibrierung mit einem Verzögerungswert programmiert zu werden;
ein variables Verzögerungselement (40, 42, 43, 44), das eine variable Verzögerung aufweist, die durch den im SAR gespeicherten Verzögerungswert gesteuert wird, wobei das variable Verzögerungselement konfiguriert ist, einen Eingabeprobentakt (TS1, TS2, TS3, TS4) durch die variable Verzögerung zu verzögern, um den verzögerten Takt (T1, T2, T3, T4) zu erzeugen; zum Analogschalter;
einen Produktderivatkorrelator (52), der konfiguriert ist, die digitale Ausgabe (T1, T2, T3, T4) eines Kanals mit der digitalen Ausgabe (T1, T2, T3, T4) benachbarter Kanäle in der Vielzahl von Kanälen zu korrelieren, um einen Produktderivatfaktor (F1, F2, F3, F4) für den Kanal zu erzeugen; und
einen Matrixprozessor (50), der konfiguriert ist, den Produktderivatfaktor (F1, F2, F3, F4) für jeden der Vielzahl von N Kanälen zu empfangen, um eine erste Matrix mit N Elementen zu bilden, die in N Reihen mit einem Element pro Reihe angeordnet sind, wobei jedes Element einen Wert des Produktderivatfaktors aufweist, der durch den Produktderivatkorrelator für einen der N Kanäle erzeugt wird, wobei der Matrixprozessor konfiguriert ist, die erste Matrix mit einer Korrelationsmatrix zu multiplizieren, um eine Zeichenmatrix mit N-1 Elementen zu erzeugen, die jeweils ein Korrelationszeichen für N-1 der Vielzahl von N Kanälen sind;
wobei die Korrelationsmatrix aus einer Verschiebungsmatrix C erzeugt wird, die eine Matrix ist, die N Zeilen und N-1 Spalten aufweist, in einem Format von:

$$
C = \begin{bmatrix}
-1 & 0 & 0 & 0 & 0 & \ldots\ldots & 0 & 0 & -1 \\
2 & -1 & 0 & 0 & 0 & \ldots\ldots & 0 & 0 & 0 \\
-1 & 2 & -1 & 0 & 0 & \ldots\ldots & 0 & 0 & 0 \\
0 & -1 & 2 & -1 & 0 & \ldots\ldots & 0 & 0 & 0 \\
& & & & \vdots & & & & \\
0 & 0 & 0 & 0 & 0 & \ldots\ldots & -1 & 2 & -1 \\
0 & 0 & 0 & 0 & 0 & \ldots\ldots & 0 & -1 & 2
\end{bmatrix} ;
$$

wobei eine Transpositionsmatrix CT eine Transponierung der Verschiebungsmatrix C ist;
wobei die Korrelationsmatrix die Transpositionsmatrix CT ist, geteilt durch eine erste Produktmatrix, wobei die erste Produktmatrix die Transpositionsmatrix CT multipliziert mit der Verschiebungsmatrix C ist;
wobei das SAR konfiguriert ist, mit den Verzögerungswerten programmiert zu werden, um Zeitversatz unter der Vielzahl von N Kanälen zu kompensieren, unter Verwendung einer Kalibrierungsroutine für sukzessive Annäherung, die das Korrelationszeichen in der Zeichenmatrix untersucht, um zu bestimmen, wann Versuchsbits im SAR eines Kanals entsprechend dem Korrelationszeichen in der Zeichenmatrix akzeptiert oder zurückgewiesen werden sollen;
wobei der Produktderivatkorrelator (52) für einen aktuellen Kanal Folgendes umfasst:

eine erste Probeverzögerung (11), die konfiguriert ist, die digitale Ausgabe (D1, D2, D3, D4) des aktuellen Kanals um einen Impuls eines Probentaktes zu verzögern, um eine erste verzögerte Probe zu erzeugen;
eine zweite Probeverzögerung (148), die konfiguriert ist, die digitale Ausgabe (D1, D2, D3, D4) eines ersten benachbarten Kanals auf den aktuellen Kanal zu verzögern, um eine zweite verzögerte Probe zu erzeugen; eine dritte Probeverzögerung (146), die konfiguriert ist, die digitale Ausgabe (D1, D2, D3, D4) eines zweiten benachbarten Kanals auf den aktuellen Kanal zu verzögern, um eine dritte verzögerte Probe zu erzeugen; einen Modulo-Umlaufeinsteller, der konfiguriert ist, die dritte Probenverzögerung (146) einzustellen, um die digitale Ausgabe (D1, D2, D3, D4) des zweiten benachbarten Kanals relativ zu dem aktuellen Kanal um zwei Impulse des Probentakts zu verzögern, um die dritte verzögerte Probe zu erzeugen, wenn der aktuelle Kanal ein erster Kanal (1) und der zweite benachbarte Kanal ein letzter Kanal (N) in der Vielzahl von N Kanälen ist; wobei der Modulo-Umlaufeinsteller auch konfiguriert ist, die zweite Probenverzögerung (148) einzustellen, um die digitale Ausgabe (D1, D2, D3, D4) des ersten benachbarten Kanals relativ zu dem aktuellen Kanal um null Impulse des Probentaktes zu verzögern, um die zweite verzögerte Probe zu erzeugen, wenn der aktuelle Kanal der letzte Kanal (N) in der Vielzahl von N Kanälen ist und der erste benachbarte Kanal der erste Kanal (1) in der Vielzahl von N Kanälen ist; wobei der erste benachbarte Kanal und der zweite benachbarte Kanal zu der Vielzahl von N Kanälen gehören; einen ersten Addierer (140), der konfiguriert ist, die dritte verzögerte Probe von der zweiten verzögerten Probe zu subtrahieren, um eine erste Summe zu erzeugen; einen ersten Multiplikator (142), der konfiguriert ist, die erste Summe mit der ersten verzögerten Probe zu multiplizieren, um ein erstes Produkt zu erzeugen; und einen Kalibrator (55) für die sukzessive Annäherung, der für jedes Korrelationszeichen in der Zeichenmatrix konfiguriert ist:

(a) dem SAR eines Kanals, der ein entsprechendes Korrelationszeichen in der Zeichenmatrix mit einem Wert von 1 aufweist, eine Testbitposition hinzuzufügen;
(b) dem SAR des Kanals, der das entsprechende Korrelationszeichen in der Zeichenmatrix mit dem Wert von 0 aufweist, die Testbitposition zu subtrahieren;

und ab (a) für sukzessive kleinere Bitpositionen im SAR zu positionieren,
wobei das Korrelationszeichen in der Zeichenmatrix verwendet wird, um sukzessive Bitpositionen im SAR hinzuzufügen oder zu subtrahieren;
wobei der Kalibrator für die sukzessive Annäherung konfiguriert ist, das SAR für einen Referenzkanal in der Vielzahl von Kanälen auf einen fixierten Wert zu setzen;
wobei der Kalibrator für die sukzessive Annäherung konfiguriert ist, den fixierten Wert in dem SAR des Referenzkanals nicht einzustellen, wobei der Kalibrator für die sukzessive Annäherung das SAR für N-1 Kanäle der Vielzahl von N Kanälen einstellt;
wobei der Produktderivatkorrelator (52) ferner Folgendes umfasst:

einen Durchschnittsgenerator (54), der konfiguriert ist, das erste Produkt über eine Vielzahl von M Proben der analogen Eingabe zu mitteln, um den Produktderivatfaktor als einen gemittelten Produktderivatfaktor zu erzeugen,
wobei M eine Ganzzahl ist.

2. Matrixkalibrierter verschachtelter ADC nach Anspruch 1, wobei der Produktderivatkorrelator in jedem Kanal ferner Folgendes umfasst:
einen Filter mit endlicher Impulsantwort (FIR), der die digitale Ausgabe von dem ADC filtert, wobei die Eingabe der digitalen Ausgabe eine gefilterte digitale Ausgabe ist.

3. Matrixkalibrierter verschachtelter ADC nach Anspruch 2, wobei N keine Zweierpotenz ist.

4. Matrixkalibrierter verschachtelter ADC nach Anspruch 2, wobei N eine ungerade Zahl ist.

5. Matrixkalibrierter verschachtelter ADC nach Anspruch 2, wobei die digitale Ausgabe des ADC mindestens 6 Bit beträgt.

6. Matrixkalibrierter verschachtelter ADC nach Anspruch 1, wobei das variable Verzögerungselement eine Vielzahl binär gewichteter Kondensatoren umfasst, die jeweils durch ein Bit im SAR aktiviert werden.

7. Matrixkalibrierter verschachtelter ADC nach Anspruch 1, ferner umfassend:
eine Hintergrundkalibrierungsroutine, die aktiviert wird, um Einstellungen in den SARs einzustellen, die zuvor durch Kalibrierung eingestellt wurden, die Hintergrundkalibrierungsroutine umfassend:

(a) für jeden Kanal:

die Hintergrundkalibrierungsroutine ist zum Eingeben der digitalen ADC-Ausgaben von einem aktuellen Kanal und von einem vorherigen benachbarten Kanal und von einem nächsten benachbarten Kanal in einen Produktderivatkorrelator konfiguriert, der einen geprobten Produktderivatfaktor erzeugt, der die Korrelation der digitalen ADC-Ausgabe des aktuellen Kanals mit der digitalen ADC-Ausgabe des vorherigen benachbarten Kanals und der digitalen ADC-Ausgabe des nächsten benachbarten Kanals quantifiziert;

die Hintergrundkalibrierungsroutine ist zum Mitteln des geprobten Produktderivatfaktors über mehrfache Proben der analogen Eingabe konfiguriert, um einen Produktderivatfaktor für den aktuellen Kanal zu erzeugen;

die Hintergrundkalibrierungsroutine ist zum Anordnen der Produktderivatfaktoren für alle Kanäle in einer Faktorenmatrix konfiguriert;

die Hintergrundkalibrierungsroutine ist zum Multiplizieren der Faktormatrix mit einer Korrelationsmatrix konfiguriert, um eine Zeichenmatrix zu erzeugen, die N-1 Zeichenbits aufweist, die den Kanälen 2 bis N entsprechen;

für alle Kanäle mit Ausnahme des Referenzkanals:

(b) die Hintergrundkalibrierungsroutine ist zum Hinzufügen eines Testbits mit niedrigstwertigem Bit (LSB) an einer LSB-Bit-Position in der SAR eines ausgewählten Kanals konfiguriert, um den Verzögerungswert einzustellen, wenn das Zeichenbit in der Zeichenmatrix, die dem ausgewählten Kanal entspricht, 1 ist und wenn das Zeichenbit aus einer vorherigen Iteration 1 war;

(c) die Hintergrundkalibrierungsroutine ist zum Subtrahieren des LSB-Testbits an der LSB-Bitposition in der SAR eines ausgewählten Kanals konfiguriert, um den Verzögerungswert einzustellen, wenn das Zeichenbit in der Zeichenmatrix, die dem ausgewählten Kanal entspricht, 0 ist und wenn das Zeichenbit für eine vorherige Iteration 0 war;

die Hintergrundkalibrierungsroutine ist zum Wiederholen von (a) konfiguriert, bis ein Endpunkt erreicht ist.

8. Matrixkalibrierter verschachtelter ADC nach Anspruch 1, wobei alle Produktderivatkorrelatoren konfiguriert sind, parallel betrieben zu werden, um die N Kanäle parallel zu kalibrieren.

9. Matrixkalibrierter verschachtelter ADC nach Anspruch 1, wobei mehrfache Produktderivatkorrelatoren konfiguriert sind, durch Wiederverwenden eines Produktderivatkorrelators in Form von Hardware seriell zu verarbeitet zu werden.

**Revendications**

1. Convertisseur analogique-numérique (CAN) entrelacé étalonné par matrice comprenant :
une pluralité de N canaux, dans lequel N est un nombre entier qui vaut au moins 4, dans lequel chacun de la pluralité de N canaux comprend :

un CAN (10, 12, 13, 14) qui est configuré pour convertir une entrée analogique échantillonnée en une sortie numérique (D1, D2, D3, D4) ayant une valeur numérique représentant l'entrée analogique échantillonnée ;

un commutateur manuel (20, 22, 23, 24) qui est configuré pour échantillonner une entrée analogique (AIN) recevant un signal en CA en réponse à une horloge retardée (T1, T2, T3, T4) ;

un registre à approximations successives, SAR, qui est configuré pour être programmé avec une valeur de retard pendant un étalonnage ;

un élément à retard variable (40, 42, 43, 44) ayant un retard variable qui est commandé par la valeur de retard stockée dans le SAR, l'élément à retard variable étant configuré pour retarder une horloge d'échantillonnage d'entrée (TS1, TS2, TS3, TS4) du retard variable pour générer l'horloge retardée (T1, T2, T3, T4) ; sur le commutateur analogique ;

un corrélateur de dérivée de produit (52) qui est configuré pour mettre en corrélation la sortie numérique (T1, T2, T3, T4) d'un canal avec la sortie numérique (T1, T2, T3, T4) de canaux adjacents dans la pluralité de canaux pour générer un facteur de dérivée de produit (F1, F2, F3, F4) pour le canal ; et

un processeur matriciel (50) qui est configuré pour recevoir le facteur de dérivée de produit (F1, F2, F3, F4) pour chacun de la pluralité de N canaux pour former une première matrice ayant N éléments agencés en N rangées avec un élément par rangée, chaque élément ayant une valeur du facteur de dérivée de produit généré par le corrélateur de dérivée de produit pour l'un des N canaux,

le processeur matriciel est configuré pour multiplier la première matrice par une matrice de corrélation pour générer une matrice de signes ayant N-1 éléments qui sont chacun un signe de corrélation pour N-1 de la pluralité de N canaux ;

dans lequel la matrice de corrélation est générée à partir d'une matrice de décalage C qui est une matrice ayant N rangées et N-1 colonnes dans un format de :

$$C = \begin{bmatrix} -1 & 0 & 0 & 0 & 0 & \ldots\ldots & 0 & 0 & -1 \\ 2 & -1 & 0 & 0 & 0 & \ldots\ldots & 0 & 0 & 0 \\ -1 & 2 & -1 & 0 & 0 & \ldots\ldots & 0 & 0 & 0 \\ 0 & -1 & 2 & -1 & 0 & \ldots\ldots & 0 & 0 & 0 \\ & & & & \vdots & & & & \\ 0 & 0 & 0 & 0 & 0 & \ldots\ldots & -1 & 2 & -1 \\ 0 & 0 & 0 & 0 & 0 & \ldots\ldots & 0 & -1 & 2 \end{bmatrix} ;$$

dans lequel une matrice transposée CT est une transposée de la matrice de décalage C ;

dans lequel la matrice de corrélation est la matrice transposée CT, divisée par une première matrice de produit, dans lequel la première matrice de produit est la matrice transposée CT multipliée par la matrice de décalage C ;

dans lequel le SAR est configuré pour être programmé avec les valeurs de retard pour compenser des écarts de temporisation entre la pluralité de N canaux à l'aide d'une routine d'étalonnage à approximations successives qui examine le signe de corrélation dans la matrice de signes pour déterminer le moment auquel accepter ou rejeter des bits d'essai dans le SAR d'un canal correspondant au signe de corrélation dans la matrice de signes ;

dans lequel le corrélateur de dérivée de produit (52) pour un canal actuel comprend :

un premier retard d'échantillon (11) qui est configuré pour retarder la sortie numérique (D1, D2, D3, D4) du canal actuel d'une impulsion d'une horloge d'échantillon pour générer un premier échantillon retardé ;

un deuxième retard d'échantillon (148) qui est configuré pour retarder la sortie numérique (D1, D2, D3, D4) d'un premier canal adjacent au canal actuel pour générer un deuxième échantillon retardé ;

un troisième retard d'échantillon (146) qui est configuré pour retarder la sortie numérique (D1, D2, D3, D4) d'un deuxième canal adjacent au canal actuel pour générer un troisième échantillon retardé ;

un ajusteur d'enveloppe modulo, qui est configuré pour ajuster le troisième retard d'échantillon (146) pour retarder la sortie numérique (D1, D2, D3, D4) du deuxième canal adjacent par rapport au canal actuel de deux impulsions de l'horloge d'échantillon pour générer le troisième échantillon retardé lorsque le canal actuel est un premier canal (1) et le deuxième canal adjacent est un dernier canal (N) dans la pluralité de N canaux ;

dans lequel l'ajusteur d'enveloppe modulo est également configuré pour ajuster le deuxième retard d'échantillon (148) pour retarder la sortie numérique (D1, D2, D3, D4) du premier canal adjacent par rapport au canal actuel de zéro impulsion de l'horloge d'échantillon pour générer le deuxième échantillon retardé lorsque le canal actuel est le dernier canal (N) dans la pluralité de N canaux et le premier canal adjacent est le premier canal (1) dans la pluralité de N canaux ;

dans lequel le premier canal adjacent et le deuxième canal adjacent sont dans la pluralité de N canaux ;

un premier additionneur (140) qui est configuré pour soustraire le troisième échantillon retardé à partir du deuxième échantillon retardé pour générer une première somme ;

un premier multiplicateur (142) qui est configuré pour multiplier la première somme par le premier échantillon retardé pour générer un premier produit ; et

un étalonneur à approximations successives (55), qui est configuré, pour chaque signe de corrélation dans la matrice de signes :

(a) pour ajouter une position de bit de test au SAR d'un canal ayant un signe de corrélation correspondant dans la matrice de signes ayant une valeur de 1 ;

(b) pour soustraire la position de bit de test au SAR du canal ayant le signe de corrélation correspondant dans la matrice de signes ayant une valeur de 0 ;

et pour répéter à partir de (a) pour des positions de bits successivement inférieures dans le SAR, ce par quoi le signe de corrélation dans la matrice de signes est utilisé pour ajouter ou soustraire des positions de bits successives dans le SAR ;

dans lequel l'étalonneur à approximations successives est configuré pour régler le SAR pour un canal de référence dans la pluralité de canaux sur une valeur fixe ;

dans lequel l'étalonneur à approximations successives est configuré pour ne pas ajuster la valeur fixe dans le SAR du canal de référence, l'étalonneur à approximations successives ajustant le SAR pour N-1 canaux de la pluralité de N canaux ;

dans lequel le corrélateur de dérivée de produit (52) comprend en outre :

un générateur de moyenne (54) qui est configuré pour calculer la moyenne du premier produit sur une pluralité de M échantillons de l'entrée analogique pour générer le facteur de dérivée de produit sous la forme d'un facteur de dérivée de produit moyenné,

dans lequel M est un nombre entier.

2. CAN entrelacé étalonné par matrice selon la revendication 1 dans lequel le corrélateur de dérivée de produit dans chaque canal comprend en outre :

un filtre à réponse impulsionnelle finie (FIR) qui filtre la sortie numérique du CAN,

dans lequel la sortie numérique entrée est une sortie numérique filtrée.

3. CAN entrelacé étalonné par matrice selon la revendication 2 dans lequel N n'est pas une puissance de deux.

4. CAN entrelacé étalonné par matrice selon la revendication 2 dans lequel N est un nombre impair.

5. CAN entrelacé étalonné par matrice selon la revendication 2 dans lequel la sortie numérique du CAN est d'au moins 6 bits.

6. CAN entrelacé étalonné par matrice selon la revendication 1 dans lequel l'élément à retard variable comprend une pluralité de condensateurs à pondération binaire qui sont chacun enclenchés par un bit dans le SAR.

7. CAN entrelacé étalonné par matrice selon la revendication 1 comprenant en outre :
une routine d'étalonnage d'arrière-plan activée pour ajuster des réglages dans les SAR qui ont été précédemment réglés par étalonnage, la routine d'étalonnage d'arrière-plan comprenant :

(a) pour chaque canal :

la routine d'étalonnage d'arrière-plan configurée pour entrer les sorties numériques de CAN d'un canal actuel et d'un canal adjacent antérieur et d'un canal adjacent suivant dans un corrélateur de dérivée de produit qui génère un facteur de dérivée de produit échantillonné qui quantifie une corrélation de la sortie numérique de CAN du canal actuel avec la sortie numérique de CAN du canal adjacent antérieur et la sortie numérique de CAN du canal adjacent suivant ;

la routine d'étalonnage d'arrière-plan configurée pour calculer la moyenne du facteur de dérivée de produit échantillonné sur de multiples échantillons de l'entrée analogique pour générer un facteur de dérivée de produit pour le canal actuel ;

la routine d'étalonnage d'arrière-plan configurée pour agencer les facteurs de dérivée de produit pour tous les canaux en une matrice de facteurs ;

la routine d'étalonnage d'arrière-plan configurée pour multiplier la matrice de facteurs par une matrice de corrélation pour générer une matrice de signes ayant N-1 bits de signe correspondant aux canaux 2 à N ;

pour tous les canaux à l'exception du canal de référence :

(b) la routine d'étalonnage d'arrière-plan configurée pour ajouter un bit de test de bit le moins significatif (LSB) à une position de bit de LSB dans le SAR d'un canal sélectionné pour ajuster la valeur de retard lorsque le bit de signe dans la matrice de signes correspondant au canal sélectionné vaut 1 et lorsque le bit de signe provenant d'une itération antérieure valait 1 ;

(c) la routine d'étalonnage d'arrière-plan configurée pour soustraire le bit de test de LSB à la position de bit de LSB dans le SAR d'un canal sélectionné pour ajuster la valeur de retard lorsque le bit de signe dans la matrice de signes correspondant au canal sélectionné vaut 0 et lorsque le bit de signe pour une itération antérieure valait 0 ;

la routine d'étalonnage d'arrière-plan configurée pour répéter à partir de (a) jusqu'à ce qu'un point final soit atteint.

8. CAN entrelacé étalonné par matrice selon la revendication 1 dans lequel tous les corrélateurs de dérivée de produit sont configurés pour être mis en fonctionnement en parallèle pour étalonner les N canaux en parallèle.

9. CAN entrelacé étalonné par matrice selon la revendication 1 dans lequel de multiples corrélateurs de dérivée de produit sont configurés pour être traités en série par la réutilisation d'un corrélateur de dérivée de produit sous forme de matériel.

FIG 1

FIG 2

FIG 3

FIG 4

FIG 5

FIG 6

FIG 7A

FIG 7B

FIG 8

INTERLEAVED
ADC
_730_

SAR(J) _744_

AIN →

DOUT →

BASEBAND
MODEM / DSP
/ FPGA
_732_

→

START BACKGROUND CAL.

FIG 9

BACKGROUND
CALIBRATION,
N CHANNELS

252 — USE PRIOR VALUES
IN ALL SAR-DELAY
REGISTERS SAR(J)

AVERAGE THE PRODUCT DERIVATIVE
CORRELATIONS OVER M SAMPLES OF AIN
FOR ALL N CHANNELS TO GET F(1..N) — 260

MULTIPLY CORRELATION MATRIX BY
F(1..N) TO GET SIGN VECTOR SIGN(2..N) — 262

C

256

254 — ADD LSB TO SAR FOR
EACH CHANNEL X WITH
SIGN(X)=1

SUBTRACT LSB FROM SAR
FOR EACH CHANNEL X
WITH SIGN(X)=0

FIG 10A

258 — STORE SIGN(X) AS OLD_SIGN(X) FOR ALL

SUBTRACT LSB FROM SAR FOR EACH CHANNEL X WITH SIGN(X)=0=OLD_SIGN(X)

266

AVERAGE THE PRODUCT DERIVATIVE CORRELATIONS OVER M SAMPLES OF AIN FOR ALL N CHANNELS TO GET F(1..N) — 270

264 — ADD LSB TO SAR FOR EACH CHANNEL X WITH SIGN(X)=1=OLD_SIGN(X)

MULTIPLY CORRELATION MATRIX BY F(1..N) TO GET SIGN VECTOR SIGN(2..N) — 272

274 — UNDO +/- LSB FROM SAR FOR EACH CHANNEL X WITH SIGN(X) NOT= OLD_SIGN(X)

N

276

FLIP LIMIT?

Y

END

FIG 10B

AIN

30

N = 6 (EVEN, NON-BINARY)

T1  20  ADC_1 10  D1  FIR 17  Y1  PRODUCT DERIVATIVE CORRELATOR 52  F1
22  T2  ADC_2 12  D2  FIR 17  Y2  PRODUCT DERIVATIVE CORRELATOR 52  F2
T3  23  ADC_3 13  D3  FIR 17  Y3  PRODUCT DERIVATIVE CORRELATOR 52  F3
24  T4  ADC_4 14  D4  FIR 17  Y4  PRODUCT DERIVATIVE CORRELATOR 52  F4
T5  25  ADC_5 15  D5  FIR 17  Y5  PRODUCT DERIVATIVE CORRELATOR 52  F5
26  T6  ADC_6 16  D6  FIR 17  Y6  PRODUCT DERIVATIVE CORRELATOR 52  F6

MATRIX PROCESSOR 50

SIGN(2:6)

SAR DEL'S 40

CALIBRATOR 55

FIG 11

FIG 12

FIG 13

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2018358976 A1

- US 8159377 B2

**Non-patent literature cited in the description**

- Digital Compensation for Timing Mismatches in Interleaved ADCs. **YI RU et al.** ASIAN TEST SYMPOSIUM. PROCEEDINGS. IEEE, 18 November 2013, 134-139
- **YIN YONG-SHENG et al.** A channel multiplexing digital calibration technique for timing mismatch of time-interleaved ADCs. *IEICE ELECTRONICS EXPRESS*, 01 January 2019, vol. 16 (19), 20190540-20190540

- Fully Digital Feedforward Background Calibration of Clock Skews for Sub-Sampling TIADCs Using the Polyphase Decomposition. **LE DUC HAN et al.** IEEE TRANSACTIONS ON CIRCUITS AND SYSTEMS I: REGULAR PAPERS. IEEE, 01 June 2017, vol. 64, 1515-1528